Europäisches Patentamt

European Patent Office

Office européen des brevets

(11) Publication number: 0 316 026
A1

# EUROPEAN PATENT APPLICATION

(21) Application number: 88202277.5

(22) Date of filing: 12.10.88

(51) Int. Cl.⁴: H01L 21/60

(30) Priority: 03.11.87 IT 2249187

(43) Date of publication of application:
17.05.89 Bulletin 89/20

(84) Designated Contracting States:
DE FR GB NL

(71) Applicant: PRESIDENZA DEL CONSIGLIO DEI MINISTRI -UFFICIO DEL MINISTRO PER IL COORDINAMENTO DELLE INIZIATIVE PER LA RICERCA SCIENTIFICA E TECNOLOGICA 76, Lungotevere Thaon di Revel
I-00100 Roma(IT)

(72) Inventor: Blandano, Francesco
Via Silvio Pellico, 15
I-20011 Corbetta MI(IT)

(74) Representative: Coggi, Giorgio
ITALTEL Società Italiana Telecomunicazioni s.p.a. (Servizio Brevetti) Casella Postale 10
I-20019 Settimo Milanese (MI)(IT)

(54) Procedure for soldering a semiconductor component (chip) to a supporting unit.

(57) The invention uses a procedure in which the following operations are carried out:
   1) positioning the chip (3) on that area of the supporting unit (2) where soldering is to take place;
   2) placing a small amount of solder (13) near the chip;
   3) raising the temperature of elements (2), (3) and (13) to the point at which the solder will melt.

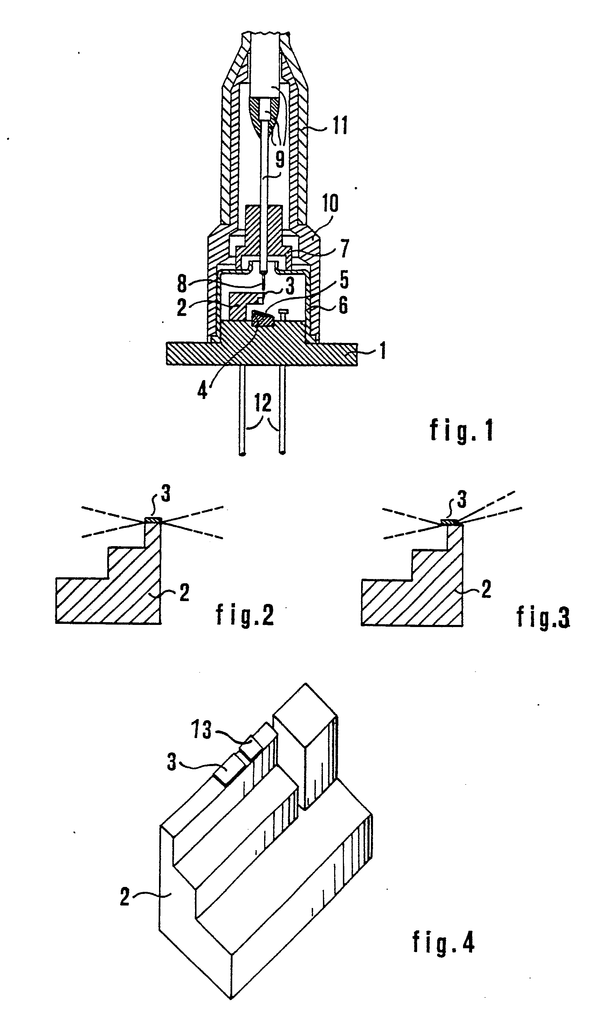

When the soldering alloy becomes a liquid, it "wets" the edges of the chip and, thanks to the principle of capillarity, wetting is then extended to the entire surface area of contact between the chip and the supporting element (figure 4).

fig.4

## PROCEDURE FOR SOLDERING A SEMICONDUCTOR COMPONENT (CHIP) TO A SUPPORTING UNIT

The present invention regards a procedure for soldering a semiconductor component - henceforth indicated by the term "chip"-to a supporting element.

The procedure which is described below refers in particular to soldering a laser diode to a support unit known in specific technological terms as a "submount". This procedure may however be advantageously employed in all cases where chips of any type must be soldered in a precise position on any type of submount, provided that the surfaces of the chip and the submount concerned in the procedure show predetermined "wettability" properties, as will be better illustrated below.

In the field of optic fibre transmissions systems, functional units known as "modules" are used, usually composed of a laser diode, a photoconductive diode detector and a segment (or piece) of optic fibre (pig tail). In particular, the diode laser is attached to a submount which positions it between the photoconductive diode detector and the optic fibre, so that it can transmit the luminous radiations given off from the front and from behind, from the chip to the optic fibre and to the photoconductive diode detector.

In the case in point, an "edge emitter" type diode laser is used -that is, a type in which liminous radiations are given off from two opposite edges of the device - and consequently, in this case placement of the chip must be extremely precise (the edge of the chip must coincide with the edge of the submount) to avoid the risk of reflection of luminous radiation.

Considering the extremely small dimensions of the submount, (the soldering operation takes place on a surface which is 300 microns wide) and the dimensions of the chip (approximately 400 microns wide, 300 microns long and 80 microns thick), it becomes clear that precise positioning of these units during the soldering cycle creates considerable problems.

It has in fact been observed that unacceptable results are obtained when normal soldering procedures are amployed of the type used when the above positioning problems do not exist. These well-known procedures in fact, provide for the following:

1) placing a small amount of the solder on the surface of the submount where soldering is to take place;

2) positioning the chip on the solder;

3) heating the above elements until the solder reaches the melting point.

The unacceptable results are caused by the fact that, when the solder becomes a liquid, the chip, in most cases, either turns or shifts position to a degree exceeding the above mentioned placement tolerance limits.

For this reason, this procedure cannot be used in the soldering of diode lasers, because of the above positioning difficulties. In order to better understand the problems connected with soldering operations of the type in question, it is necessary to analyze the "wettability" properties of the soldering alloys normally used, that is, the capacity that these alloys have of "wetting" the surrounding surfaces when they become loquids as a consequence of raising their temperature to beyond the melting point.

The alloys normally used are in fact either indium-based alloys or gold-tin alloys.

When indium-based alloys are raised to melting point, they tend to contract and take the shape of sphere, showing a very low intrinsic capacity for "wetting" (intrinsic wettability) in a non-reducing environment, that is, an environment in which oxide formation is impeded by using a hydrogen atmosphere.

Given the precautions which it is necessary to adopt (for safety reasons) when heating a substance in the presence of hydrogen, soldering procedures carried out in a reducing environment (in the presence of hydrogen) have proved to be economically inconvenient and a procedure has been developed - also well-known - using so-called "fluxing" liquids. These liquids are capable of de-oxidizing the surface on which soldering operations are to take place, consequently increasing the intrinsic wettability of the soldering alloys.

In this procedure, the following operations are carried out in order:

1) de-oxidizing the submount surface with fluxing liquid at the point where soldering is to take place;

2) placing a small amount of solder on the fluxed area;

3) raising the temperature of the above elements to the melting point of the solder which, on contact with the submount surface, de-oxidized by the fluxing liquid, wets a sufficient amount of surface area to permit soldering;

4) rinsing the submount to eliminate fluxing liquid residues;

5) de-oxidizing the melted solder with fluxing liquid to eliminate the particles of oxide formed on the alloy;

6) positioning the chip on the fluxed area;

7) placing a weight on the chip to limit its shifting during the soldering cycle;

8) re-melting the soldering alloy by a further rise in temperature;

9) rinsing the submount-chip unit to eliminate fluxing liquid residues.

The above procedure is inconvenient in that it is a lengthy operation, and it employs fluxing liquids which in this case cause problems to arise principally concerning residues which persist even after rinsing operations have been carried out.

The first problem involves contamination of the diode laser mirrors, causing particularly negative effects on the performance of the device.

The second problem is caused by the fact that, since these liquids are chlorine-based, residues of this element migrate with time to the metallic parts, causing their deterioration and consequent loss of module reliability over a certain time period.

To eliminate these inconveniences, a gold-tin soldering alloy is sometimes used, which, when heated, does not tend to contract like indium-based alloys, but tends to wet a limited part of the surrounding surface area, thanks to its intrinsic wettability. This intrinsic wettability is however, insufficient for soldering operations, and a procedure has been developed, also well-known, to improve this property. This method uses either fluxing liquids or mechanical operations.

The method using fluxing liquids coincides with the above mentioned procedure for indium-based soldering alloys and presents the same already-cited drawbacks regarding the use of these fluxing liquids.

The method using mechanical operations differs from the above in that de-oxidation using fluxing liquids and consequent rinsing operations are not carried out (see points 1,5,4 and 9 of the well-known method), while a mechanical operation is carried out at point 3 and consists in spreading the melted solder with a metallic pin to enlarge the wetted area.

This mechanical operation permits an increase in the surface area wetted, but it has been observed that the process, carried out in this way, has low ripetitivity properties, since it is not possible to control the thickness of the solder.

With regard to the above procedures, the method using mechanical manipulation of the solder does not present the same inconveniences as those originating from the use of fluxing liquids, but it introduces repetitivity problems which have a negative effect on the efficiency of the procedure.

The object of the present invention is to develop a procedure which is free of the above mentioned difficulties and which can be carried out in particularly short operating times.

The invention procedure overcomes the above mentioned wettability problems by exploiting the physical principal of "capillarity"- that is, that series of circumstances, due to the interaction between molecules of a liquid (or of an alloy heated to the point at which it becomes a liquid) and the molecules of a solid on their contact surfaces, which determine the capillary movement of the molecules wetting the surfaces of contact.

Studies carried out by the applicant have shown in particualr, that the wettability problems of gold-tin alloys can be resolved by creating conditions exploiting the principle of capillarity, as will be demonstrated by the sequence of operations described below which refer to the procedure developed in the invention.

1) Positioning the chip on that area of the submount where soldering is to take place;

2) placing a small amount of solder at a distance from the chip which is not less than the intrinsic wettability of the solder, that is, to its horizontal spreading as it passes from the solid to the liquid state;

3) raising the temperature of the above elements for a period of time not less than that pre-determined.

Essentially, when the soldering alloy becomes a liquid, it tends to expand horizontally to a degree equal to that of its intrinsic wettability. The surface of the chip and that of the submount with which it is in contact, simulate a capillary structure. When the liquid wets the edges of the chip therefore, it moves by capillary action to cover the entire surface between the chip and the submount, hence wetting the entire surface involved in the soldering operation in a pre-determined time period.

Further characteristics of this discovery will be seen from the following description of an example which is not restrictive in its execution and which is accompanied by the enclosed illustrations, in which:

- figure 1 shows the elements composing a module for optic fibre transmission systems;

- figure 2 shows the submount 2 and the diode laser 3 of figure 1, where the latter element is correctly positioned;

- figure 3 shows the submount 2 and the diode laser 3 of figure 1, where the latter element is incorrectly positioned;

- figure 4 shows a soldering operation carried out according to the procedure outlined in the invention.

Figure 1 shows the module used in optic fibre transmission systems. This module consists of a flange 1 with two submounts located on its central area: the first submount 2 is made for holding a diode laser 3, while the second submount 4 is made for holding a photoconductive diode detector 5. Submount 2 shows an essentially square-cut section, on the free end of which the diode laser 3 may be soldered. The above elements are protected by a covering 6, with a hole for a centering device 7. The function of the latter is to position the optic fibre 8 frontally with respect to the diode laser 3, so that the luminous radiation given off by it may be received and conveyed on the transmission line. The optic fibre 8 is covered with many sheaths 9, giving it a high mechanical resistance.

The above elements are protected by an external bushing 10, with one end welded to the flange 1, while the other end holds the optic fibre 8 through its sheaths 9.

Part of the external bushing 10, part of the optic fibre 8 and its relative sheaths 9, are also protected by a heat-shrunk protective sheath 11.

The module is also composed of rheophores 12, which are electrically connected with the above mentioned optoelectronic elements. Considering the above , it is evident that the function of submount 2 is to hold the diode laser 3 in such a way that the luminous radiation given off either in front and behind by this chip, may reach the optic fibre 8, and the photoconductive diode detector 5. In the application concerned, the positioning of the chip 3 on the surface of the submount 2 is of decisive importance for optimizing the transfer or luminous radiation to the optic fibre and to the detector, as will be made more evident in the description of figures 2 and 3.

Figures 2 and 3 in fact, show - in large scale and turned at a 90° angle with respect to the position in figure 1 - the submount 2 and diode laser 3. In particular, in figure 2 the latter is shown correctly positioned while in figure 3 it has been positioned incorrectly.

In fact, it may be observed that in figure 2 the luminous radiations given off by the device do not encounter any obstacle, while in figure 3, they hit the submount causing reflections which have negative effects of the transfer of luminous energy to the optic fibre.

It is therefore evident that any shifting or rotation of the chip as it is being soldered to the submount is unacceptable for specific applications.

Figure 4 shows a phase of the method used in the invention, which provides for the operations specified below:

1) positioning the diode laser 3 on the surface of the submount 2 on the point at which soldering is to take place, in such a way that the operation is done as illustrated in figure 2;

2) placing a small plate of solder 13 next to the diode laser 3 at a distance less than the amount that it will spread (intrinsic wettability) when it becomes a liquid;

3) raising the temperature of the above elements (submount 2, diode laser 3, solder 13) to the point where the solder will melt and remain in a liquid state for a predetermined time period.

On the basis of studies carried out by the applicant, it has been observed that the optimum distance cited in point 2 is 0,1 mm. and that the optimum duration of the time parameter cited in point 3 is approximately 30 seconds. During this time interval, the soldering alloy becomes a liquid, wetting the surrounding area and, on coming into contact with the edge of the chip, moves by capillary action into the space between the two surfaces of the diode laser 3 and the submount 2.

It has been observed that:
- the diode laser is not shifted on contact with the solder;
- the solder dioes not run onto the diode laser mirrors;
- the thickness of the solder assumes contant and optimal values spontaneously.

In consideration of the above features, it should be evident that the method used in the invention is considerably advantageous compared to the well-known method used to date for the following reasons;
- can be implemented in a time that is inferior to the time necessary to carry out the known procedure;
- it is not necessary to use fluxing liquids which, as mentioned previously, may contaminate the diode laser mirrors with solid residues and/or may cause the melted solder to run onto the mirrors;
- it does not require placing weigths on the diode laser, which could damage it or might in any case jeopardize its reliability;
- it shows excellent repeatability properties;
- it gives a very high yield, since it is free of the difficulties pointed out previously with reference to the well-known procedures used to date;
- optimum results are obtained when a gold-tin alloy is used as the soldering solder. Compared to indium-based alloys, the gold -tin alloy is considerably advantageous from a standpoint of reliability, as demonstrated in the technical report entitled: "Aging characteristics of $Ga_{1-x} Al_x$ As double heterostructure laser bonded with gold eutectic alloy solder" by K. Fujiwara - T. Fujiwara - K. hori and M. Takusagowa (Appl. Phys. Lett, 34. 10, 15 May 1979).

To carry out the procedure descrived in the invention, it is not necessary to supplement the equipment already used in the previous method. This apparatus consists of:
- a device known in this specific field with the term "pick and place", made from clasping the diode laser and the solder and positioning them on the submount;

- a device known in this specific field with the term "die attach" consisting of a heating plate and a mechanism which sprays the submount with a gas mixture (97% nitrogen and 3% hydrogen) allowing the procedure to take place in a controlled atmosphere.

In consideration of the above facts, it is evident that the method developed in the invention fully satisfies all the requirements set forth as its objectives, since it can be carried out in a very limited time period and it eliminates all the inconveniences previously pointed out with reference to the well-known procedures used to date.

## Claims

1) Procedure for soldering a semiconductor component (chip) to a supporting element, characterized by carrying out the following operations:
- positioning of the chip (3) on the surface of the supporting element (2) where soldering is to take place;
- placing a small amount of solder (13) at a distance from the chip not less than the intrinsic wettability of the solder, that is, not less than the horizontal spreading of the solder as it melts to become a liquid;
- raising the temperature of the above elements (2,3,13) for a length of time not less than a predetermined period.

2) Procedure as in claim 1, characterized by the fact that the solder 13 consists of a gold-tin alloy and that the distance from the chip (3) at which the solder (13) is to be placed is approximately 0.1 mm.

3) Procedure as in claim 1, characterized by the fact that the solder (13) consists of a gold-tin alloy and the fact that the time interval lasts for approximately 30 seconds.

4) Procedure as in claim 1, characterized by the fact that the supporting unit (2) consists of a submount and by the fact that the chip (3) consists of a laser.

fig.1

fig.2

fig.3

fig.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | FR-A-2 118 101 (PHILIPS)<br>* Figure 4; claims 1;2 *<br>--- | 1 | H 01 L 21/60 |
| A | EP-A-0 119 691 (STC)<br>* Abstract *<br>----- | 2-4 | |

TECHNICAL FIELDS SEARCHED (Int. Cl.4)

H 01 L

The present search report has been drawn up for all claims

| Place of search | Date of completion of the search | Examiner |
|---|---|---|
| THE HAGUE | 07-02-1989 | DE RAEVE R.A.L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)